# EUROPEAN PATENT APPLICATION

(11) **EP 2 793 398 A2**
(43) Date of publication of application: **22.10.2014**
(21) Application number: 14161225.9
(22) Date of filing: 24.03.2014
(51) Int. Cl.: H03K 17/955

(54) **Non-contact operation detection device for vehicle**

(30) Priority: 19.04.2013 JP 2013087934
(71) Applicant: AISIN SEIKI KABUSHIKI KAISHA, Kariya-shi, Aichi 448-8650 (JP)
(72) Inventor: Hirota, Koichi, Kariya-shi, Aichi 448-8650 (JP); Urase, Hiroshi, Kariya-shi, Aichi 448-8650 (JP); Takayanagi, Hitoshi, Kariya-shi, Aichi 448-0027 (JP)
(74) Representative: TBK

(57) **Abstract**

A non-contact operation detection device (10) for a vehicle (1) includes: a spacer (21); a sensor electrode (20) supported on a first surface (21 a) of the spacer; a first electrode (24) supported on a second surface (21 b) on a side opposite to the first surface of the spacer; and a determination unit determining a change in capacitance detected by the sensor electrode.

## Description

### TECHNICAL FIELD

This disclosure relates to a non-contact operation detection device for a vehicle that is used in a backdoor, a slide door, and the like.

### BACKGROUND DISCUSSION

In recent years, a so-called non-contact operation detection device for a vehicle is in use in a vehicle such as a car so that an operator can perform door opening operation on a backdoor, a slide door, and the like on a non-contact basis.

For example, Japanese Patent No. 4514603 (Reference 1) discloses a door opening switch device allowing a non-contact operation of a vehicle backdoor. In the door opening switch device of Japanese Patent No. 4514603 (Reference 1), a plating portion of a backdoor garnish is configured to have a capacitance sensor having a sensor electrode, and a change in capacitance caused when the operator approaches the device is detected such that the non-contact operation by the operator is recognized. In addition, an LED is disposed in the door opening switch device of Japanese Patent No. 4514603 (Reference 1), and the LED is driven and lighted when the operator approaches the device.

In the above-described non-contact operation detection device for a vehicle of the related art, the distance between the sensor electrode and a GND electrode changes when positions of the garnish where the sensor electrode is disposed and a body that is the GND electrode are shifted due to vibration or the like. This causes the capacitance, that is, stray capacitance, to change. The change in the stray capacitance may be erroneously detected as the non-contact operation by the operator.

In addition, when voltage is applied to a metallic body disposed in the non-contact operation detection device for a vehicle such as sensor electrode wiring and the LED, the capacitance detected by the sensor electrode changes, which may result in an erroneous detection.

These erroneous detections become severe as the non-contact operation detection device for a vehicle has an increasing sensitivity in response to the non-contact operation by the operator.

### SUMMARY

An aspect of this disclosure is directed to a non-contact operation detection device for a vehicles including: a spacer; a sensor electrode supported on a first surface of the spacer; a first electrode supported on a second surface on a side opposite to the first surface of the spacer; and a determination unit determining a change in capacitance detected by the sensor electrode.

According to the non-contact operation detection device for a vehicle of the aspect of this disclosure, the first electrode is disposed on the side opposite to the sensor electrode across the spacer such that the first electrode is arranged between the body and the sensor electrode. Accordingly, the first electrode is shielded, and the capacitance between the body and the sensor electrode is reduced. As a result, the change in the capacitance between the sensor electrode and the body due to vibration or the like can be blocked.

Since the spacer is disposed, the distance between the sensor electrode and the first electrode can be adjusted with ease such that the sensitivity of the sensor electrode is optimized.

In addition, according to the non-contact operation detection device for a vehicle of this disclosure, the sensor electrode and the first electrode are supported with the spacer, and thus the change in the distance between the sensor electrode and the first electrode due to vibration or the like can be suppressed, and a variation of the capacitance detected by the sensor electrode can be prevented. Accordingly, even when vibration or the like is generated, the erroneous detection as the non-contact operation by the operator can be prevented.

Another aspect of this disclosure is directed to the non-contact operation detection device for a vehicle described above, wherein a thickness of the spacer is greater than thicknesses of the sensor electrode and the first electrode in a cross-sectional view in which the spacer, the sensor electrode, and the first electrode are cut after the spacer, the sensor electrode, and the first electrode are assembled.

Since the thickness of the spacer is greater than the thicknesses of the sensor electrode and the first electrode, the sensor electrode and the first electrode can be separated from each other with enough distance, and therefore the sensitivity of the sensor electrode can be improved.

Still another aspect of this disclosure is directed to the non-contact operation detection device for a vehicle described above, wherein the spacer is a member separate from a substrate of the sensor electrode and a substrate of the first electrode.

Even when an existing substrate is used as the substrate of the sensor electrode and the substrate of the first electrode, the sensor electrode and the first electrode can be separated from each other with enough distance by the spacer because the spacer is a member separate from these substrates and therefore the sensitivity of the sensor electrode can be improved.

Yet another aspect of this disclosure is directed to the non-contact operation detection device for a vehicle described above, which further includes: a second electrode; and a sensor electrode wiring connected to the sensor electrode, wherein at least a part of the sensor electrode wiring is covered to be interposed between the first electrode and the second electrode.

According to the non-contact operation detection device for a vehicle of the aspect of this disclosure, at least a part of the sensor electrode wiring is covered to be interposed between the first electrode and the second electrode. As such, the capacitance detected by the sensor electrode does not change and the variation of the capacitance detected by the sensor electrode can be prevented even when sensor electrode wiring is displaced due to vibration or the like or voltage is applied to drive wiring such as the sensor electrode wiring and an LED so as to drive the sensor electrode. Accordingly, the erroneous detection due to vibration or the like can be prevented.

Still yet another aspect of this disclosure is directed to the non-contact operation detection device for a vehicle described above, which further includes: a light-emitting diode arranged on a fourth surface side on a side opposite to a third surface of the first electrode which faces the second surface of the spacer; a light-emitting diode wiring connected to the light-emitting diode, at least a part of the light-emitting diode wiring being covered to be interposed between the first electrode and the second electrode; and a light-emitting diode circuit unit (152) driving the light-emitting diode via the light-emitting diode wiring.

Further another aspect of this disclosure is directed to the non-contact operation detection device for a vehicle described above, wherein the sensor electrode, the first electrode, the determination unit, the second electrode, the sensor electrode wiring, the light-emitting diode, the light-emitting diode wiring, and the light-emitting diode circuit unit are disposed on a flexible printed circuit board.

Still further another aspect of this disclosure is directed to the non-contact operation detection device for a vehicle described above, wherein a plurality of the sensor electrodes are provided, the determination unit is capable of individually determining changes in capacitances detected by the plurality of sensor electrodes, and directionality of a vehicle operation on a vehicle intended by an operator is recognized in response to the determination.

Yet further another aspect of this disclosure is directed to the non-contact operation detection device for a vehicle described above, wherein each of the first electrode and the second electrode is one of a GND electrode, a shield electrode, and a drive electrode.

Still yet further another aspect of this disclosure is directed to the non-contact operation detection device for a vehicle described above, wherein the sensor electrode and the first electrode are fixed to the spacer.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a schematic partial cross-sectional view of a non-contact operation detection device for a vehicle according to a first embodiment disclosed here;
Fig. 2 is a partial cross-sectional view of the non-contact operation detection device for a vehicle according to the first embodiment disclosed here;
Figs. 3A and 3B are plan views of a flexible printed circuit board of a non-contact operation detection device for a vehicle according to a second embodiment disclosed here; and Fig. 4 is a cross-sectional view of the non-contact operation detection device for a vehicle according to the second embodiment disclosed here.

### DETAILED DESCRIPTION

Hereinafter, a non-contact operation detection device for a vehicle disclosed here will be described with reference to the accompanying drawings. The drawings illustrated herein may employ a scale different from the actual scale for ease of understanding.

### First Embodiment

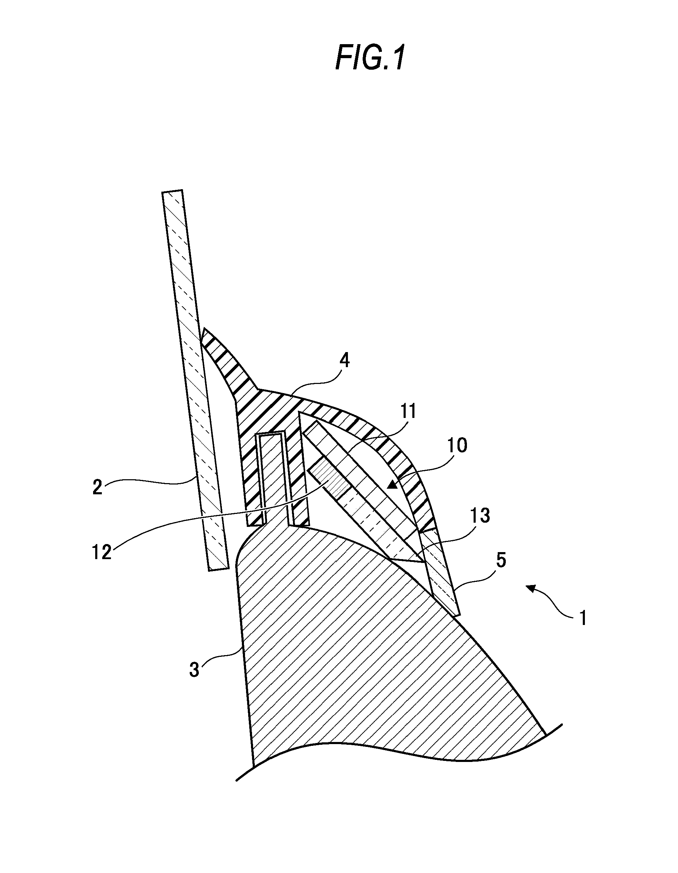

Fig. 1 is a schematic partial cross-sectional view of a vehicle 1 on which a non-contact operation detection device 10 for a vehicle according to a first embodiment disclosed here is mounted.

A belt molding 4 is disposed along a window glass 2 and a door panel 3 of the vehicle 1, and the non-contact operation detection device 10 for a vehicle is installed in the belt molding 4. The non-contact operation detection device 10 for a vehicle is configured to include a capacitance sensor 11 and a light-emitting diode (LED) 12. Light that is emitted from the LED 12 passes through a light guide plate 13 and is emitted from a transmitting resin 5 which is disposed in the belt molding 4. In this manner, an operator can find a position of the non-contact operation detection device 10 for a vehicle with ease.

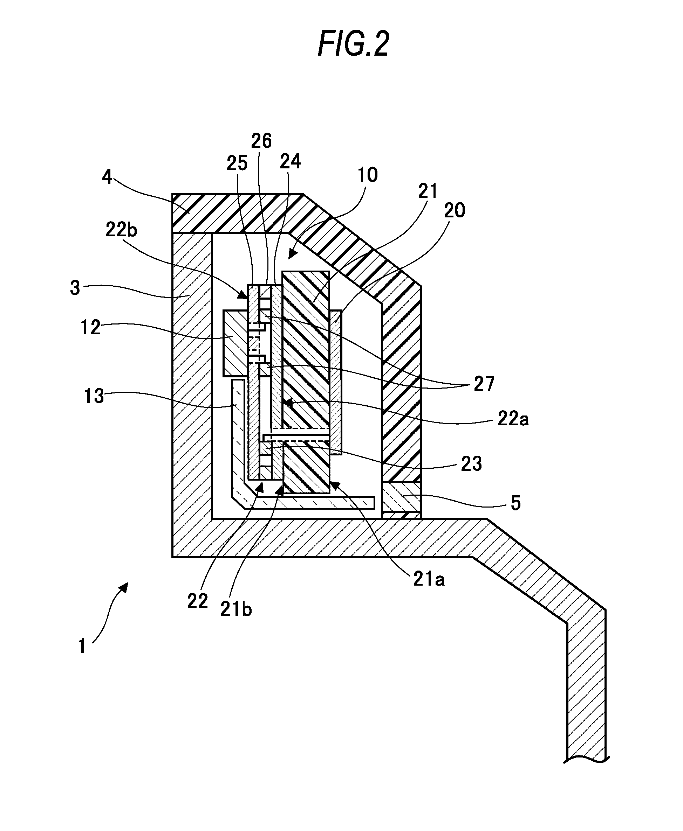

Fig. 2 is a partial cross-sectional view illustrating the vehicle 1 on which the non-contact operation detection device 10 for a vehicle according to the first embodiment disclosed here is mounted.

The non-contact operation detection device 10 for a vehicle includes a sensor electrode 20, a spacer 21, a GND electrode portion 22, and a sensor electrode wiring (metallic body) 23. In addition, the non-contact operation detection device 10 for a vehicle includes the LED (metallic body) 12 and LED wiring (metallic body) 27. The sensor electrode 20 is supported on a surface 21 a (first surface) on the side opposite to a surface 21 b of the spacer 21 which faces the door panel 3, and the GND electrode portion 22 is supported on the surface 21 b (second surface) of the spacer 21. Accordingly, the GND electrode portion 22 is arranged between the sensor electrode 20 and the door panel 3. In addition, the LED 12 is supported on a surface 22b (fourth surface) on the side opposite to a surface 22a (third surface) of the GND electrode portion 22 which faces the surface 21 b of the spacer 21.

The GND electrode portion 22 is configured to have a first GND electrode (first electrode) 24, a second GND electrode (second electrode) 25, and a GND electrode connection portion 26. The first GND electrode 24 and the second GND electrode 25 are connected to each other by the GND electrode connection portion 26, and are covered such that at least a part of the sensor electrode wiring 23 and at least a part of the LED wiring (light-emitting diode wiring) 27 are interposed between the first GND electrode 24 and the second GND electrode 25. One end of the sensor electrode wiring 23 is connected to the sensor electrode 20 through an opening that is disposed at a part of the first GND electrode 24 and at a part of the spacer 21, and the other end of the sensor electrode wiring 23 is connected to a sensor electrode circuit unit (determination unit, not shown). One end of the LED wiring 27 is connected to the LED 12 through an opening that is disposed at a part of the second GND electrode 25, and the other end of the LED wiring 27 is connected to an LED circuit unit (not shown).

With this configuration, the non-contact operation detection device 10 for a vehicle disclosed here performs the following operation to detect a non-contact operation by the operator.

First, when the operator approaches the vehicle 1 with a device including an oscillator which has an LF oscillator circuit or the like, a circuit (not shown) in the non-contact operation detection device 10 for a vehicle detects electromagnetic waves oscillated by the oscillator. Then, the non-contact operation detection device 10 for a vehicle lights the LED 12 so as to show the position of the non-contact operation detection device 10 for a vehicle to the operator. The light that is emitted from the lighted LED 12 passes through the light guide plate 13 and is emitted from the transmitting resin 5 which is disposed in the belt molding 4.

When a part of the body of the operator approaches the non-contact operation detection device 10 for a vehicle, capacitance that is detected by the sensor electrode 20 changes, and the determination unit (not shown) of the non-contact operation detection device 10 for a vehicle determines the capacitance change and the non-contact operation detection device 10 for a vehicle recognizes that the operator performs the non-contact operation.

Since the first GND electrode 24 is disposed between the sensor electrode 20 and the door panel 3 in the non-contact operation detection device 10 for a vehicle disclosed here, the first GND electrode 24 is shielded such that the capacitance change between the door panel 3 and the sensor electrode 20 is reduced. As a result, the sensor electrode 20 can be shielded by the first GND electrode 24. Accordingly, the capacitance change between the sensor electrode 20 and the door panel 3 caused when the door panel 3 is displaced due to vibration or the like can be prevented.

In addition, since the sensor electrode 20 and the first GND electrode 24 are supported with the spacer 21 in the non-contact operation detection device 10 for a vehicle disclosed here, a change in a distance between the sensor electrode 20 and the first GND electrode 24 due to vibration or the like can be suppressed, and thus a variation of the capacitance detected by the sensor electrode can be prevented. Accordingly, an erroneous detection of the sensor electrode 20 due to vibration or the like can be prevented.

For example, the sensor electrode 20 has higher sensitivity as away at a distance from the first GND electrode 24, and thus the distance between the sensor electrode 20 and the first GND electrode 24 may be several millimeters to 10 mm. However, in a case where the sensor electrode and the first GND electrode are respectively arranged on both surfaces of a substrate in a simple manner by using a circuit substrate, a flexible printed circuit board, or the like, the distance between the electrodes is limited to approximately 0.1 mm to 2 mm and the sensitivity of the sensor electrode is reduced. Meanwhile, since the spacer 21 is used here, any distance can be set between the sensor electrode 20 and the first GND electrode 24, and thus the sensitivity of the sensor electrode 20 can be optimized.

Furthermore, in the non-contact operation detection device 10 for a vehicle disclosed here, at least a part of the sensor electrode wiring 23 is shielded by the first GND electrode 24 and the second GND electrode 25. As such, the capacitance with respect to the sensor electrode 20 does not change and the variation of the capacitance detected by the sensor electrode 20 can be prevented even when the sensor electrode wiring 23 is displaced due to vibration or the like or voltage is applied to the sensor electrode wiring 23 so as to drive the sensor electrode 20. Accordingly, the erroneous detection due to vibration or the like can be prevented.

Likewise, in the non-contact operation detection device 10 for a vehicle disclosed here, the LED wiring 27 is shielded by the first GND electrode 24 and the second GND electrode 25. Accordingly, the change in the capacitance detected by the sensor electrode 20 is suppressed even when the LED wiring 27 is displaced due to vibration or the like or voltage is applied to the LED wiring 27 so as to drive the LED 12. Accordingly, the erroneous detection due to vibration or the like can be prevented.

In addition, the disclosure can be applied even when a light emission method other than the LED is used.

In the non-contact operation detection device 10 for a vehicle disclosed here, the LED 12 is supported on the surface 22b on the side opposite to the surface 22a of the GND electrode portion 22 which faces the spacer 21. Accordingly, even when potential changes when the LED 12 is driven, the change in the capacitance detected by the sensor electrode 20 caused by the driving of the LED 12 can be suppressed since the sensor electrode 20 is shielded by the GND electrode portion 22.

### Second Embodiment

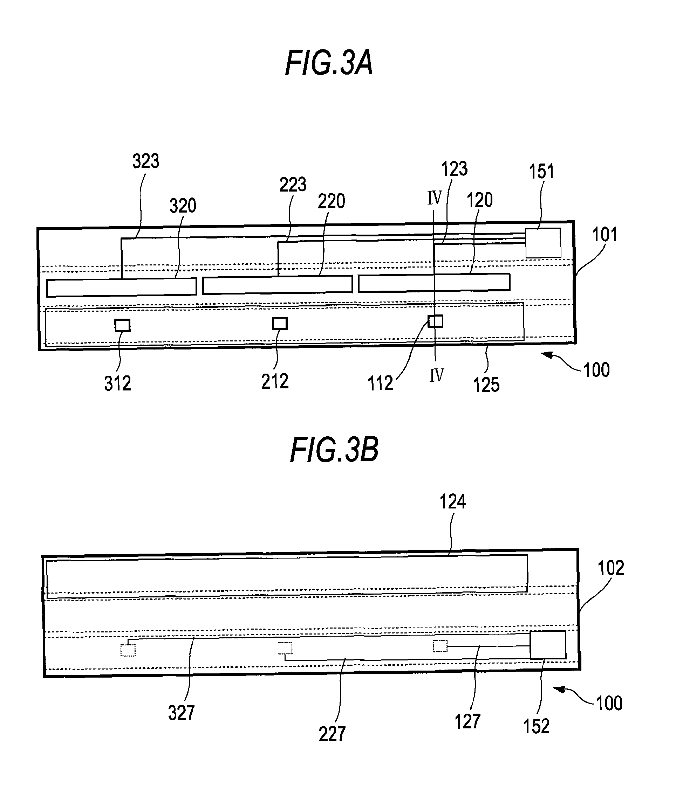

Figs. 3A and 3B respectively illustrate plan views of a flexible printed circuit board (hereinafter referred to as "FPC") 100 for assembly of a non-contact operation detection device 110 for a vehicle according to a second embodiment disclosed here viewed from one surface 101 and the other surface 102.

As illustrated in Fig. 3A, a first sensor electrode 120, a second sensor electrode 220, a third sensor electrode 320, and a second GND electrode 125 are disposed on the one surface 101 of the FPC 100. In addition, a first LED 112, a second LED 212, a third LED 312, and a sensor electrode circuit unit (determination unit) 151 are disposed on the one surface 101 of the FPC 100. The first sensor electrode 120, the second sensor electrode 220, and the third sensor electrode 320 are connected to the sensor electrode circuit unit 151 by respective sensor electrode wiring 123, 223, and 323 which are arranged on the one surface 101.

As illustrated in Fig. 3B, a first GND electrode 124 and an LED circuit unit (light-emitting diode circuit unit) 152 are disposed on the other surface 102 of the FPC 100. The first LED 112, the second LED 212, and the third LED 312 are connected to the LED circuit unit 152 by respective LED wiring 127, 227, and 327 which are disposed on the other surface 102.

When the FPC 100 is bent along the dotted line of Fig. 3A, the non-contact operation detection device 110 for a vehicle according to the second embodiment disclosed here can be assembled.

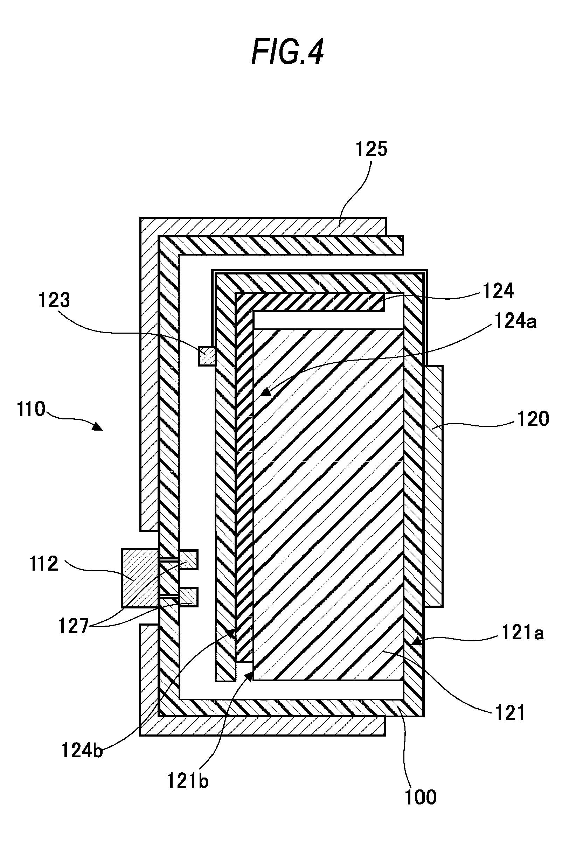

Fig. 4 is a cross-sectional view illustrating the non-contact operation detection device 110 for a vehicle according to the second embodiment disclosed here and assembled in this manner taken along line IV-IV of Fig. 3A.

It is apparent in Fig. 4 that the non-contact operation detection device 110 for a vehicle has a similar structure as the non-contact operation detection device 10 for a vehicle according to the first embodiment disclosed here.

In other words, the sensor electrode 120 is supported on a surface 121 a (first surface) side of a spacer 121, and the first GND electrode 124 is supported on a surface 121 b (second surface) on the side opposite to the surface 121 a of the spacer 121. In addition, the LED 112 is arranged on a surface 124b (fourth surface) side on the side opposite to a surface 124a (third surface) of the first GND electrode 124 which faces the surface 121 b of the spacer 121.

In addition, at least a part of the sensor electrode wiring 123 that is connected to the sensor electrode 120 and at least a part of the LED wiring 127 that is connected to the LED 112 are covered to be interposed between the first GND electrode 124 and the second GND electrode 125.

Accordingly, as is the case with the non-contact operation detection device 10 for a vehicle, an erroneous detection of the sensor electrode 120 can be prevented in the non-contact operation detection device 110 for a vehicle according to the second embodiment disclosed here.

In this manner, the non-contact operation detection device 110 for a vehicle according to the second embodiment disclosed here can be assembled just by bending the FPC 100 if a circuit is formed in advance on the FPC 100. Accordingly, the non-contact operation detection device 10 for a vehicle with the basic configuration illustrated in the first embodiment disclosed here can be manufactured by an easy manufacturing method, with a small number of components, and at a low manufacturing cost.

Although the three sensor electrodes are formed on the FPC 100, the number of the sensor electrodes that can be formed on the FPC 100 is not limited thereto.

It is preferable that the spacers 21 and 121 that are used herein be made of a material having a stable dielectric constant in external environments. Suitable examples thereof include an ABS resin and polyethylene terephthalate.

In the non-contact operation detection device for a vehicle disclosed here, the sensor electrode and the first GND electrode may be fixed to the spacer.

During the fixing, the sensor electrode 120 is fixed to the spacer 121 via the FPC 100 in the case of the non-contact operation detection device 110 for a vehicle.

The non-contact operation detection device for a vehicle disclosed here is mounted in the belt molding, but can also be mounted on a garnish such as a pillar and a backdoor, a mud guard mounted on a lower end of a door, an emblem, a resin door and a body panel, a bumper, a spoiler, aero parts, a door trim, a roof trim, a seat, resinous interior and exterior parts mounted in the vicinity of a body, and the like.

In addition, the non-contact operation detection device for a vehicle disclosed here can perform an operation such as opening and closing of a swing door of a vehicle, opening and closing of a slide door, opening and closing of a backdoor, opening and closing of a power window, opening and closing of a sunroof, lighting of lighting and display devices, and various seat operations in response to the detection of the non-contact operation by the operator.

For example, in a case where the operator is engaged in the non-contact operation with the sensor electrodes 120, 220, and 320 in order when the non-contact operation detection device 110 for a vehicle that is assembled by bending the FPC 100 is mounted in the belt molding of the slide door, the sensor electrode circuit unit 151 can recognize the operation as a movement of the slide door directed from the sensor electrodes 120 to 320. As such, the slide door is moved from the sensor electrodes 120 to 320. In other words, directionality can be given to the non-contact operation by the operator by using a plurality of the sensor electrodes.

In addition, in the non-contact operation detection device for a vehicle disclosed here, the GND electrode is used so as to block an influence of the metallic body on the capacitance detected by the sensor electrode, but another electrode can also be used instead of the GND electrode. In other words, a shield electrode for the application of the same potential as the sensor electrode and a drive electrode for the application of a predetermined potential may be used.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

A non-contact operation detection device (10) for a vehicle (1) includes: a spacer (21); a sensor electrode (20) supported on a first surface (21 a) of the spacer; a first electrode (24) supported on a second surface (21 b) on a side opposite to the first surface of the spacer; and a determination unit determining a change in capacitance detected by the sensor electrode.

## Claims

1. A non-contact operation detection device (10) for a vehicle (1) comprising:
a spacer (21);
a sensor electrode (20) supported on a first surface (21 a) of the spacer;
a first electrode (24) supported on a second surface (21 b) on a side opposite to the first surface of the spacer; and
a determination unit determining a change in capacitance detected by the sensor electrode.

2. The non-contact operation detection device for a vehicle according to claim 1,
wherein a thickness of the spacer is greater than thicknesses of the sensor electrode and the first electrode in a cross-sectional view in which the spacer, the sensor electrode, and the first electrode are cut after the spacer, the sensor electrode, and the first electrode are assembled.

3. The non-contact operation detection device for a vehicle according to claim 1 or 2,
wherein the spacer is a member separate from a substrate of the sensor electrode and a substrate of the first electrode.

4. The non-contact operation detection device for a vehicle according to any one of claims 1 to 3, further comprising:
a second electrode (25); and
a sensor electrode wiring (23) connected to the sensor electrode,
wherein at least a part of the sensor electrode wiring is covered to be interposed between the first electrode and the second electrode.

5. The non-contact operation detection device for a vehicle according to claim 4, further comprising:
a light-emitting diode (12) arranged on a fourth surface (22b) side on a side opposite to a third surface (22a) of the first electrode which faces the second surface of the spacer;
a light-emitting diode wiring (27) connected to the light-emitting diode, at least a part of the light-emitting diode wiring being covered to be interposed between the first electrode and the second electrode; and
a light-emitting diode circuit unit (152) driving the light-emitting diode via the light-emitting diode wiring.

6. The non-contact operation detection device for a vehicle according to claim 5,
wherein the sensor electrode, the first electrode, the determination unit, the second electrode, the sensor electrode wiring, the light-emitting diode, the light-emitting diode wiring, and the light-emitting diode circuit unit are disposed on a flexible printed circuit board.

7. The non-contact operation detection device for a vehicle according to any one of claims 1 to 6,
wherein a plurality of the sensor electrodes are provided,
wherein the determination unit is capable of individually determining changes in capacitances detected by the plurality of sensor electrodes, and
wherein directionality of operation on a vehicle intended by an operator is recognized in response to the determination.

8. The non-contact operation detection device for a vehicle according to any one of claims 4 to 6,
wherein each of the first electrode and the second electrode is one of a GND electrode, a shield electrode, and a drive electrode.

9. The non-contact operation detection device for a vehicle according to any one of claims 1 to 8,
wherein the sensor electrode and the first electrode are fixed to the spacer.
